Europäisches Patentamt

European Patent Office

Office européen des brevets

(19)

(11) Publication number: 0 305 166
A1

# (12) EUROPEAN PATENT APPLICATION

(21) Application number: 88307844.6

(22) Date of filing: 24.08.88

(51) Int. Cl.4: **H 01 R 9/09**

(30) Priority: 28.08.87 GB 8720352

(43) Date of publication of application:
01.03.89 Bulletin 89/09

(84) Designated Contracting States: CH DE FR IT LI

(71) Applicant: POLYHITECH
Luton Road
Dunstable Bedfordshire LU5 4LJ (GB)

(72) Inventor: Shaw, Graham
13 Page Hill Avenue
Buckingham Bucks (GB)

(74) Representative: Cross, Rupert Edward Blount et al
BOULT, WADE & TENNANT 27 Furnival Street
London EC4A 1PQ (GB)

(54) Electrical connection pin.

(57) An electrical connection pin, for surface mounting on a substrate, comprises an elongate member (1) having adjacent one end (2) a circumferential shoulder (3) facing the one end (2). When soldered on a substrate with the one end (2) of the pin is contact with a track on the substrate, the pin is secured by a truncated cone of solder extending between the track and the shoulder (3) on the pin.

FIG. 1.

EP 0 305 166 A1

**Description**

ELECTRICAL CONNECTION PIN

This invention relates to an electrical connection pin, and particularly to an electrical connection pin for mounting on a substrate such as a printed circuit board.

For many years electrical connection pins have been mounted on substrates by having a portion of the pin received in a hole in the substrate, the pin being retained either by frictional engagement with the hole wall alone, or by the use of solder.

Recently, there has been a move towards the use of surface mounted components for mounting on substrates, that is components which do not require the provision of holes in the substrate but which are secured as by soldering to the surface of the substrate, and thus there is a need for a connection pin which can be easily and reliably mounted on a substrate in such manner.

According to this invention there is provided an electrical connection pin comprising an elongate member of electrically conductive material having adjacent one end a circumferential shoulder adjacent one end and facing said one end.

The shoulder can be integrally formed on the pin or can otherwise be provided by a separate member secured to the pin.

When the pin of this invention is mounted on a substrate, with said one end in contact with the substrate, by means of solder, then the solder can be applied to form a truncated cone extending between the substrate and the shoulder on the pin. The pin is thus much more reliably secured to the substrate than would be the case if there was solder only between said one end of the pin and the substrate as would be the case if solder initially applied to the substrate was relied on as is generally the case with surface mounted components.

The ability easily to provide the truncated cone of solder compensates for the relatively small surface area of said one end of the pin, which would otherwise be the only area over which the pin would be secured to the substrate, and obviates the need for any carrier member used to carry the pin to the substrate to remain on the substrate to assist in supporting the pin.

Preferably a tubular member of solder is mounted on the pin between the shoulder and said one end.

By this means all of the volume of solder necessary for mounting the pin can be provided in an easy and convenient manner, any solder provided on the substrate being required only to serve a wetting function.

The tubular member of solder can be produced by stamping or pressing the member from a sheet or ribbon of solder.

This invention also provides an assembly comprising a substrate and at least one pin according to the invention mounted thereon, in which the or each pin is secured to the substrate by solder in the form of a truncated cone extending between the substrate and the shoulder on the pin.

Such an assembly can be manufactured by a method comprising removably mounting one or more pins according to the invention in a carrier member with said one end of the or each pin exposed; applying said one end of the or each pin to a substrate; soldering the or each pin to the substrate; and removing the carrier member from the or each pin.

Surface mounting components are generally applied to a substrate using a vacuum tool, and thus the carrier member is preferably shaped for holding by such a tool.

This invention will now be described by way of example with reference to the drawings, in which:-

Figure 1 is a side elevational view of an electrical connection pin according to this invention;

Figure 2 is a view similar to Figure 1 but with the pin rotated 90° about its longitudinal axis;

Figure 3 is a bottom plan view of the pin of Figures 1 and 2;

Figures 4 and 5 illustrate a manner in which a plurality of pins each as shown in Figures 1 to 3 can be mounted on a substrate;

Figure 6 is a side elevational view of another electrical connection pin according to the invention; and

Figure 7 is a bottom plan view of the pin of Figure 6.

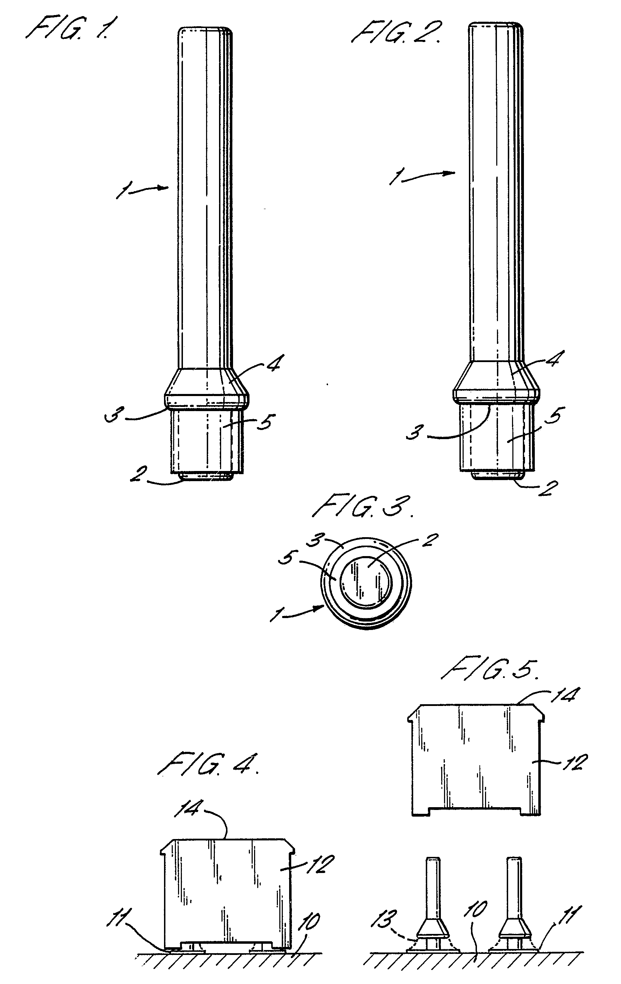

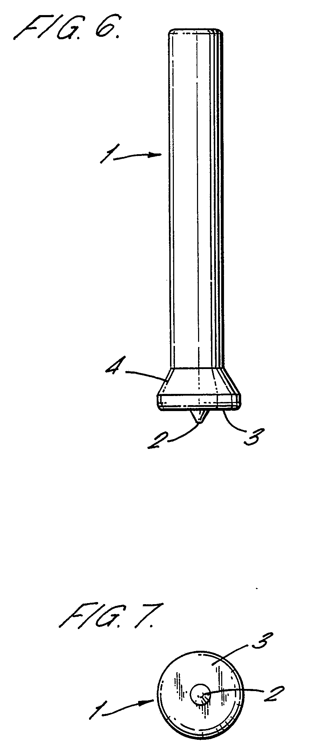

The pin shown in Figures 1 to 3 comprises an elongate circular cross-section member 1 of electrically conductive material, such as hard drawn brass, having adjacent one end 2 a circumferential shoulder 3 facing the end 2. The shoulder 3 is annular and is formed by the base of a truncated cone 4 formed on the member 1. A tubular member 5 of solder is mounted on the pin between the shoulder 3 and the end 2.

Referring now to Figures 4 and 5, for mounting on a substrate 10 such as a printed circuit board having conductive tracks 11, a plurality of pins such as shown in Figures 1 to 3 with solder members mounted thereon, are mounted in a carrier member 12 of plastics material, with the one ends 2 of the pins exposed in a common plane. The carrier member 12 with the pins therein is then applied to the substrate 10 until the ends 2 of the pins come into contact with the tracks 11 on the substrate, and the solder members on the pins are then melted and allowed to harden whereby the pins become soldered to the tracks 11. The tracks 11 may have a solder coating which will serve a wetting function. The carrier member 12 is then removed as shown in Figure 5, to leave the pins surface mounted in a required array on the substrate 10.

As indicated in Figure 5, the solder 13 securing the pins remains in the form of a truncated cone extending between the track 11 on the substrate 10 and the shoulder 3 on the pin, this form of the solder giving secure mounting of the pin, particularly against bending forces tending to shear the solder/track interface.

As noted above, the tracks 11 need be given a coating of solder sufficient only for wetting purposes, if any at all, and thus the use of solder members carried by the pins avoids the necessity for, for example, multiple screen printing operations to provide sufficient solder on the tracks 11 for securing the pins.

As shown in Figures 4 and 5, the carrier member 12 has a planar upper surface 14 which renders it suitable for use with conventional vacuum apparatus used for locating components on substrates.

Further, although in the above description a plurality of pins are simultaneously mounted, it will be appreciated that they can otherwise be mounted individually.

Although as described above each pin preferably carries a tubular member of solder, it is not essential for such a separate solder member to be used, a solder track on a substrate on which a pin is to be mounted providing sufficient solder for retention of the pin.

Figures 6 and 7 of the drawings show a pin for use without a separate tubular member of solder. Parts corresponding to parts of the pin of Figures 1 to 3 have the same references. In this pin the portion of the pin between the shoulder 3 and the end 2 is of considerably reduced size, both in length and cross-section, as compared with the corresponding portion of the pin of Figures 1 to 3.

With this pin solder on a track (11 in Fig. 4 & 5) on a substrate (10 in Fig. 4 & 5) on which the pin is mounted forms a truncated cone extending between the track and the shoulder 3 on the pin, as with the pin of Figures 1 to 3.

## Claims

1. An electrical connection pin comprising an elongate member (1) of electrically conductive material, characterised by a circumferential shoulder (3) adjacent one end (2) and facing said one end (2).

2. A pin as claimed in Claim 1, characterised in that the shoulder (3) is integrally formed on the pin.

3. A pin as claimed in Claim 1, characterised in that the shoulder (3) is provided by a separate member secured to the pin.

4. A pin as claimed in any preceding claim, characterised in that the portion of the member (1) between the shoulder (3) and said one end (2) is of reduced cross-section as compared with the remainder of the member (1).

5. A pin as claimed in Claim 1, Claim 2 or Claim 3, characterised by a tubular member of solder mounted on the pin between the shoulder (3) and said one end (2).

6. An assembly comprising a substrate and at least one pin as claimed in any preceding claim mounted thereon, characterised in that the or each pin is secured to the substrate (10) by solder (13) in the form of a truncated cone extending between the substrate (10) and the shoulder (3) on the pin.

7. A method of manufacturing an assembly as claimed in Claim 6, characterised by the steps of removably mounting one or more pins as claimed in any one of Claims 1 to 5 in a carrier (12) member with said one end (2) of the or each pin exposed; applying said one end (2) of the or each pin to a substrate; soldering the or each pin to the substrate (10); and removing the carrier member (12) from the or each pin.

8. A method as claimed in Claim 7, characterised in that the carrier member (12) is moved by means of a vacuum tool, the carrier member being shaped (14) for holding by such a tool.

FIG. 1.

1

4
3
5
2

FIG. 2.

1

4
3
5
2

FIG. 3.

3    2
5
1

FIG. 5.

14
12

FIG. 4.

14
12
11    10

13    10    11

FIG. 6.

FIG. 7.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | DE-A-2 735 746 (LOEWE OPTA)<br>* Page 7, lines 1-24; figures 1-2 * | 1,3 | H 01 R 9/09 |
| A | FR-A-2 287 121 (DU PONT DE NEMOURS)<br>* Page 2, lines 9-34; figures 1-3 * | 1,3,6,7 | |

TECHNICAL FIELDS
SEARCHED (Int. Cl.4)

H 01 R 4/00
H 01 R 9/00
H 01 R 43/00
H 05 K 3/00
H 05 K 13/00

The present search report has been drawn up for all claims

| Place of search | Date of completion of the search | Examiner |
|---|---|---|
| THE HAGUE | 04-10-1988 | CERIBELLA G. |

EPO FORM 1503 03.82 (P0401)